# EUROPEAN PATENT SPECIFICATION

(11) **EP 3 611 762 B1**
(45) Date of publication and mention of the grant of the patent: **06.03.2024**
(21) Application number: 19183086.8
(22) Date of filing: 28.06.2019
(51) Int. Cl.: H01L 23/522, H01L 27/12, H01L 27/088, H01L 25/065, H01L 23/48, H01L 23/538, H01L 23/528, H01L 23/00

(54) **STRUCTURES AND METHODS FOR LARGE INTEGRATED CIRCUIT DIES**
STRUKTUREN UND VERFAHREN FÜR GROSSE INTEGRIERTE SCHALTUNGS-CHIPS
STRUCTURES ET PROCÉDÉS POUR MATRICES DE CIRCUITS INTÉGRÉS DE GRANDE TAILLE

(30) Priority: 14.08.2018 US 201816103809
(43) Date of publication of application: 19.02.2020
(73) Proprietor: INTEL Corporation, Santa Clara, CA 95054 (US)
(72) Inventor: Gomes, Wilfred, Portland, OR 97229 (US); Bohr, Mark, Aloha, OR 97007 (US); Doyle, Brian S., Portland, OR 97229 (US)
(74) Representative: Goddar, Heinz J.

(56) References cited:
- WO-A1-2016/048753
- WO-A1-2018/125162
- US-A1- 2008 157 225
- US-A1- 2009 283 898
- US-A1- 2011 246 746
- US-A1- 2013 052 781
- US-A1- 2015 102 419
- US-A1- 2015 179 568
- US-A1- 2016 118 338
- US-A1- 2017 194 248
- US-A1- 2017 323 843
- US-A1- 2017 358 562
- US-A1- 2018 182 709
- LI LI ET AL: "Addressing bandwidth challenges in next generation high performance network systems with 3D IC integration", ELECTRONIC COMPONENTS AND TECHNOLOGY CONFERENCE (ECTC), 2012 IEEE 62ND, IEEE, 29 May 2012 (2012-05-29), pages 1040-1046, XP032210717, DOI: 10.1109/ECTC.2012.6248964 ISBN: 978-1-4673-1966-9

## Description

### Background

Integrated circuit (IC) dies are typically formed in an array on a semiconductor wafer, then separated by singulation.

US 2017/194248 A1 discloses a multi-layer semiconductor structure and methods for fabricating multi-layer semiconductor structures. The multi-layer semiconductor structure includes at least two semiconductor structures, each of the at least two semiconductor structures having first and second opposing surfaces. Additionally, each of the at least two semiconductor structures includes a first section having first and second opposing surfaces and a plurality of electrical connections extending between select portions of the first and second surfaces. Each of the at least two semiconductor structures also includes a second section having first and second opposing surfaces, with the first surface of the second section disposed over and coupled to the second surface of the first section. Methods for fabricating a multi-layer semiconductor structure from a plurality of semiconductor structures are also provided.

US 2015/179568 A1 discloses a method and an apparatus of a three dimensional integrated circuit. The apparatus includes a first tier and a second tier, wherein the second tier is above the first tier. The first tier includes a first cell. The second tier includes a second cell and a third cell. The third cell includes a first ILV to couple the first cell in the first tier to the second cell in the second tier. The third cell further includes a second ILV, the first ILV and the second ILV are extended along a first direction. The first tier further includes a fourth cell. The second tier further includes a fifth cell. The second ILV of the third cell is arranged to connect the fourth cell of the first tier with the fifth cell of the second tier. In some embodiments, the second tier further includes a spare cell including a spare ILV for ECO purpose.

US 2009/283898 A1 discloses pass-through 3D interconnects and microelectronic dies and systems of stacked dies that include such interconnects to disable electrical connections. In one embodiment of this document, a system of stacked dies includes a first microelectronic die having a backside, an interconnect extending through the first die to the backside, an integrated circuit electrically coupled to the interconnect, and a first electrostatic discharge (ESD) device electrically isolated from the interconnect. A second microelectronic die has a front side coupled to the backside of the first die, a metal contact at the front side electrically coupled to the interconnect, and a second ESD device electrically coupled to the metal contact. In another embodiment of this document, the first die further includes a substrate carrying the integrated circuit and the first ESD device, and the interconnect is positioned in the substrate to disable an electrical connection between the first ESD device and the interconnect.

US 2011/246746 A1 discloses various embodiments including apparatuses, stacked devices and methods of forming dice stacks on an interface die. In one such apparatus, a dice stack includes at least a first die and a second die, and conductive paths coupling the first die and the second die to the common control die. In some embodiments of this document, the conductive paths may be arranged to connect with circuitry on alternating dice of the stack. In other embodiments of this document, a plurality of dice stacks may be arranged on a single interface die, and some or all of the dice may have interleaving conductive paths.

US 2015/102419 A1 discloses a semiconductor device and a method of manufacturing thereof. According to one embodiment of this document, a semiconductor device includes a first complementary semiconductor device provided on a semiconductor substrate, and including a CMOS circuit, a metal electrode provided above the first complementary semiconductor device, a semiconductor layer provided above the metal electrode, including an nMOS region and a pMOS region separated from each other, and containing Ge, and a second complementary semiconductor device including an nMOSFET provided on the first portion of the semiconductor layer and a pMOSFET provided on the second portion of the semiconductor layer.

US 2018/182709 A1 discloses integrated circuit interconnect structures having a metal oxide adhesive layer between conductive interconnects and dielectric material, as well as related apparatuses and methods. For example, in some embodiments of this document, an integrated circuit interconnect structure may include a dielectric layer having 60% or more filler, a conductive layer, and a metal oxide adhesive layer between the dielectric and conductive layers. In some embodiments, the metal oxide adhesive layer may include one or more of aluminum oxide, chromium oxide, and nickel oxide.

WO 2016/048753 A1 relates to integration of electronic elements on the backside of a semiconductor die. Systems and methods include a first semiconductor die with a substrate having a first side and a second side opposite to the first side. A first set of electronic elements is integrated on the first side. A second set of electronic elements is integrated on the second side. One or more through-substrate vias through the substrate are used to couple one or more of the first set of electronic elements and one or more of the second set of electronic elements. The through-substrate vias may be through-silicon vias or a through-glass vias. The first semiconductor die may be stacked with a second semiconductor die, with the first side or the second side of the first semiconductor die interfacing an active side of the second semiconductor die.

US 2017/358562 A1 discloses an integrated display system with multi-color light emitting diodes. The display system comprises a light emitting diode (LED) device and a backplane (BP) device. The LED device comprises a plurality of LEDs having LED terminals. An LED bonding surface comprising a dielectric layer with LED bonding surface contact pads is coupled to diode terminals of the LEDs. The BP device comprises a BP substrate having top and bottom surfaces. A plurality of system on chip (SoC) chips are bonded to chip pads disposed on a bottom surface of the BP device. The SoC chips are electrically coupled to the CMOS components of the BP device and LEDs of the LED device.

### Summary

The object of the present invention is solved by claim 1. Advantageous embodiments are described by the dependent claims.

### Brief Description of the Drawings

Embodiments will be readily understood by the following detailed description in conjunction with the accompanying drawings. To facilitate this description, like reference numerals designate like structural elements. Embodiments are illustrated by way of example, not by way of limitation, in the figures of the accompanying drawings.
FIGS. 1A-1C are views of a large integrated circuit (IC) die, in accordance with various embodiments.
FIG. 2 is a side, cross-sectional view of an example large IC die, in accordance with various embodiments.
FIG. 3 is a side, cross-sectional view of an example IC die assembly including a large IC die, in accordance with various embodiments.
FIGS. 4A and 4B are views of another example IC die assembly including a large IC die, in accordance with various embodiments.
FIGS. 5A and 5B are views of another example IC die assembly including a large IC die, in accordance with various embodiments.
FIG. 6 is a top view of another example IC die assembly including a large IC die, in accordance with various embodiments.
FIG. 7 is a top view of another example large IC die, in accordance with various embodiments.
FIGS. 8A-8C illustrate stages in an example process of manufacturing a large IC die, in accordance with various embodiments.
FIGS. 9A-9C illustrate stages in an example process of manufacturing a large IC die, in accordance with various embodiments.
FIG. 10 is a flow diagram of an example method of manufacturing a large IC die, in accordance with various embodiments.
FIG. 11 is a top view of a wafer and dies that may include a large IC die, in accordance with any of the embodiments disclosed herein.
FIG. 12 is a side, cross-sectional view of an IC package that may include a large IC die, in accordance with various embodiments.
FIG. 13 is a side, cross-sectional view of an IC device assembly that may include a large IC die, in accordance with any of the embodiments disclosed herein.
FIG. 14 is a block diagram of an example electrical device that may include a large IC die, in accordance with any of the embodiments disclosed herein.

### Detailed Description

Disclosed herein are structures and methods for large integrated circuit (IC) dies, as well as related assemblies and devices. For example, an IC die according to the invention as claimed includes the features of claim 1. The IC die comprises: a first subvolume including first electrical structures, wherein the first electrical structures include devices in a first portion of a device layer of the IC die; a second subvolume including second electrical structures, wherein the second electrical structures include devices in a second portion of the device layer of the IC die; and a third subvolume including electrical pathways between the first subvolume and the second subvolume; wherein the IC die has an area greater than 750 square millimeters.

Complex computing devices may require a large number of different computing components, such as processing devices, memory, sensors, and controllers. Conventionally, each of these components is manufactured and packaged separately, then the separate components are coupled together to form the computing device. However, utilizing separately packaged components may limit how close interacting components may be positioned to each other, and thus limit the speed with which the components can interact. Further, a manufacturer of one component may need to utilize a packaged component from another manufacturer, and thus there may be a limit on how tightly the design and operation of the components may be coupled (and thus an associated limit on performance).

Integrating multiple different ones of such computing components into a single die may reduce latency and allow for tighter coupling during the design phase, but existing photolithographic techniques and related fabrication processes have been limited in the size of dies that can be reliably fabricated. For example, existing photolithographic techniques that are suitable for high volume manufacturing (HVM) utilize photomasks (also called "reticles") that can pattern an area having lateral dimensions no greater than 22 millimeters by 33 millimeters, the limit of currently commonly available lithography tools. This has meant that an IC die fabricated using such techniques may have lateral dimensions no greater than 22 millimeters by 33 millimeters. This limitation in the area of an IC die also limits the number and type of circuits that can be included in a single IC die. Conventionally, an array of such dies are formed on a semiconductor wafer, then separated into individual dies by cutting the wafer along scribe streets between adjacent dies.

Disclosed herein are structures and methods for forming IC dies larger than those conventionally achievable using HVM lithography techniques (referred to herein as "large IC dies"). Such large IC dies may include subvolumes having different functionality and/or structure, reducing latency relative to conventional assemblies of separately packaged dies, and/or providing more computing power in a single die. The large IC dies disclosed herein may be stacked with other dies to form IC die assemblies, further increasing functionality.

In the following detailed description, reference is made to the accompanying drawings that form a part hereof wherein like numerals designate like parts throughout, and in which is shown, by way of illustration, embodiments that may be practiced. It is to be understood that other embodiments may be utilized, and structural or logical changes may be made, without departing from the scope of the present disclosure. Therefore, the following detailed description is not to be taken in a limiting sense.

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The drawings are not necessarily to scale. Although many of the drawings illustrate rectilinear structures with flat walls and right-angle corners, this is simply for ease of illustration, and actual devices made using these techniques will exhibit rounded corners, surface roughness, and other features.

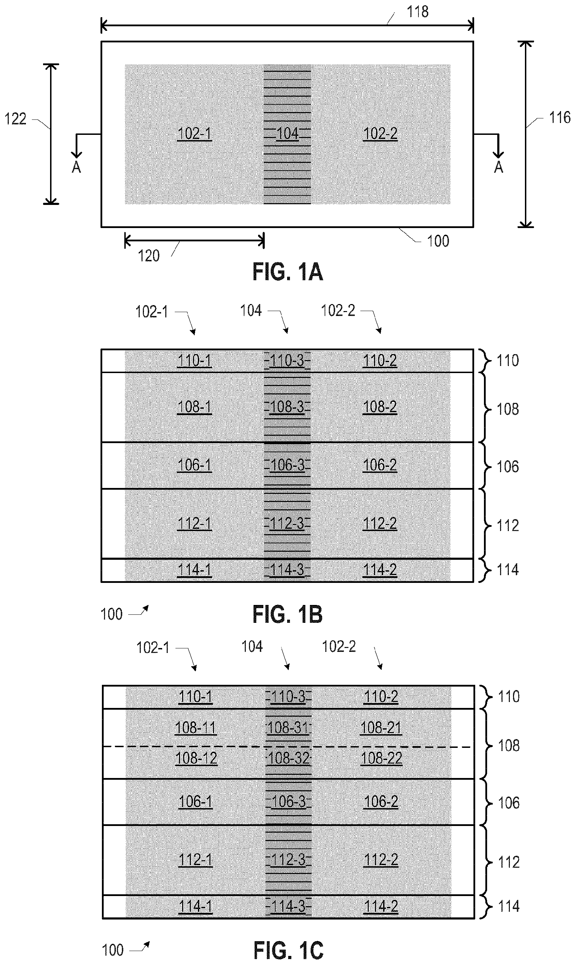

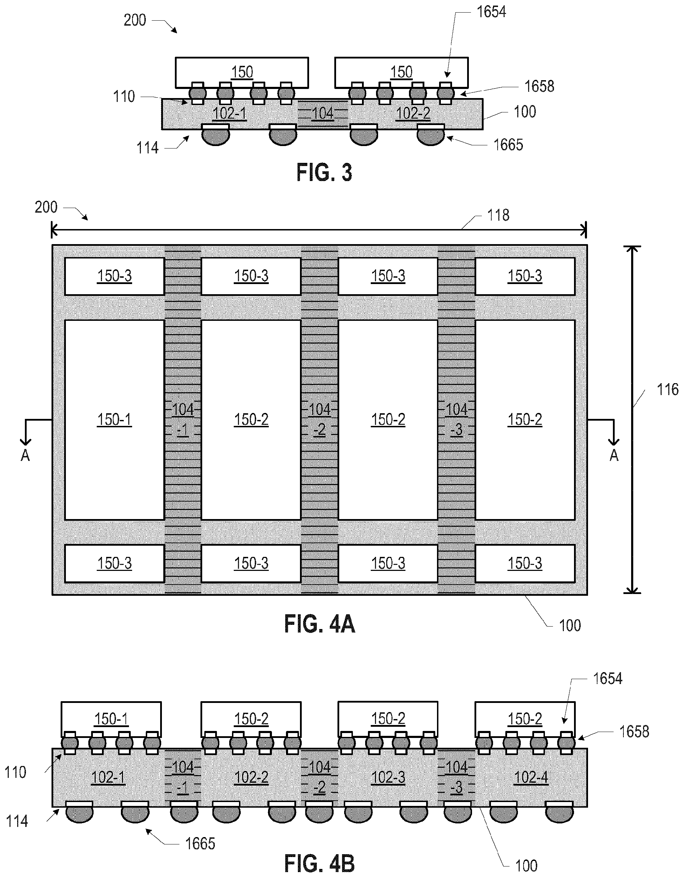

The description uses the phrases "in an embodiment" or "in embodiments," which may each refer to one or more of the same or different embodiments. Furthermore, the terms "comprising," "including," "having," and the like, as used with respect to embodiments of the present disclosure, are synonymous. As used herein, a "package" and an "IC package" are synonymous. When used to describe a range of dimensions, the phrase "between X and Y" represents a range that includes X and Y. For convenience, the phrase "FIG. 1" may be used to refer to the collection of drawings of FIGS. 1A-1C, the phrase "FIG. 4" may be used to refer to the collection of drawings of FIGS. 4A-4B, etc.

FIG. 1 illustrates an example large IC die 100. In particular, FIG. 1A is a top view of the large IC die 100, and FIG. 1B is a side, cross-sectional view through the section A-A of FIG. 1A. The large IC die 100 includes a subvolume 102-1 and a subvolume 102-2 spaced laterally apart from the subvolume 102-1. The subvolume 102-1 may be formed using a first set of photomasks, and the lateral dimensions 120 and 122 of the subvolume 102-1 may be limited to the lateral dimensions achievable using conventional HVM photolithography. For example, the lateral dimension 120 may be 22 millimeters or less and the lateral dimension 122 may be 33 millimeters or less (or vice versa). The lateral dimensions of the subvolume 102-2 may be similarly constrained.

As shown in figure 1 B, the subvolume 102-1 and the subvolume 102-2 may extend through various regions of the large IC die 100. In particular, the large IC die 100 may include top conductive contacts 110, a top metallization stack 108, a device layer 106, a bottom metallization stack 112, and bottom conductive contacts 114. As used herein, a "conductive contact" may refer to a portion of conductive material (e.g., metal) serving as an interface between different components; conductive contacts may be recessed in, flush with, or extending away from a surface of a component, and may take any suitable form (e.g., a conductive pad or socket). The subvolume 102-1 (second subvolume 102-2) may include a first portion 110-1 (second portion 110 -2) of the top conductive contacts 110, a first portion 108-1 (second portion 108 -2) of the top metallization stack 108, a first portion 106-1 (second portion 106-2) of the device layer 106, a first portion 112-1 (second portion 112 -2) of the bottom metallization stack 112, and a first portion 114-1 (second portion 114 -2) of the bottom conductive contacts 114.

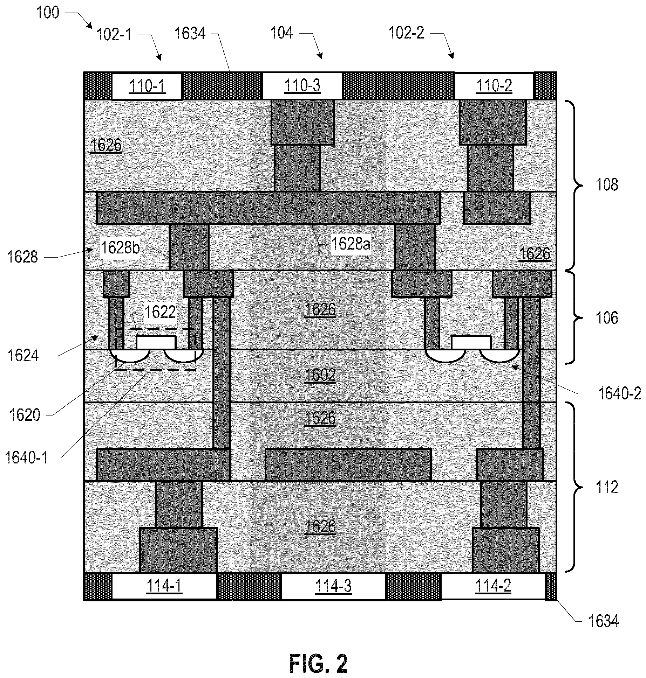

The large IC die 100 may include one or more device layers 106. Although only a single device layer 106 is depicted in FIG. 1 (and FIG. 2, discussed below), this is simply for ease of illustration, and the large IC die 100 may include more than one device layer 106. The device layer 106 may include features of one or more transistors (e.g., the transistors 1640 discussed below with reference to figure 2) or other devices. Electrical signals, such as power and/or input/output (I/O) signals, may be routed to and/or from the devices of the device layer 106 and/or other devices embedded in the large IC die 100 through the metallization stacks 108 and 112 disposed on the device layer 106. As discussed further below with reference to FIG. 2, the metallization stacks 108 and 112 may include conductive material arranged (e.g., in conductive vias and lines) to act as electrical pathways through the large IC die 100. The top conductive contacts 110 and the bottom conductive contacts 114 may provide contact points for electrical connections to be made between the large IC die 100 and other components (e.g., other dies, interposers, package substrates, etc.), as discussed further herein.

The large IC die 100 may also include a stitching subvolume 104. The stitching subvolume 104 may include electrical pathways between the subvolume 102-1 and the subvolume 102-2, and thus may electrically "stitch" circuitry of the subvolume 102-1 with circuitry of the subvolume 102-2. As illustrated in FIG. 1B, the stitching subvolume 104 may include a third portion 110-3 of the top conductive contacts 110, a third portion 108-3 of the top metallization stack 108, a third portion 106-3 of the device layer 106, a third portion 112-3 of the bottom metallization stack 112, and a third portion 114-3 of the bottom conductive contacts 114. In some embodiments, the third portion 106-3 of the device layer 106 (part of the stitching subvolume 104) may not include any active devices (e.g., may not include any transistors); in such embodiments, the stitching subvolume 104 may principally provide electrical pathways between the subvolume 102-1 and the subvolume 102-2 via the third portion 108-3 of the top metallization stack 108 and/or the third portion 112-3 of the bottom metallization stack 112. In other embodiments, the third portion 106-3 of the device layer 106 may include active devices. In some embodiments, the stitching subvolume 104 may not include any top conductive contacts 110 and/or bottom conductive contacts 114.

In some embodiments, layers of the metallization stack 108 closest to the device layer 106 may include electrical pathways (e.g., conductive vias and lines) in the first portion 108-1 and the third portion 108-3, but may not include electrical pathways in the second portion 108-2 (the portion of the metallization stack 108 in the stitching subvolume 104); the electrical pathways in the layers of the metallization stack 108 closest to the device layer 106 (in the first portion 108-1 and the third portion 108-3) may be electrical coupled by electrical pathways in the second portion 108-2 in layers "higher up" in the metallization stack 108. For example, FIG. 1C is a side view of an embodiment in which the portions of the top metallization stack 108 are shown as having "upper" and "lower" regions; the first portion 108-1 of the metallization stack 108 has an upper region 108-11 and a lower region 108-12, the second portion 108-2 of the metallization stack 108 has an upper region 108-21 and a lower region 108-22, and the third portion 108-3 of the metallization stack 108 has an upper region 108-31 and a lower region 108-32. The lower regions 108-x2 may include one or more layers of the metallization stack 108, and these one or more layers may be between the device layer 106 and one or more layers of the layers of the metallization stack in the corresponding upper regions 108-x1. In some embodiments, the lower regions 108-12 and 108-32 may include electrical pathways, while the lower region 108-22 (of the stitching subvolume 104) may not include any electrical pathways; electrical pathways between the subvolume 102-1 and the subvolume 102-2 through the stitching subvolume 104 may be made through the upper region 108-21 of the second portion 108-2 of the metallization stack 108. In some such embodiments, the second portion 106-2 of the device layer 106 may not include any devices. Such embodiments may be fabricated by first fabricating the device layer 106, then fabricating the electrical pathways in the lower regions 108-12 and 108-32, then fabricating the electrical pathways in the upper region 108-21 (and in the upper regions 108-11 and 108-31, as appropriate).

While the subvolume 102-1 and the subvolume 102-2 may have lateral dimensions that are achievable with conventional lithography (e.g., less than or equal to 22 millimeters by 33 millimeters), the subvolume 102-1, the subvolume 102-2, and the stitching subvolume 104 may together form a large IC die 100 whose lateral dimensions are larger than those achievable using conventional lithography. For example, in some embodiments, a large IC die 100 may have a lateral area (i.e., the product of the lateral dimensions 116 and 118) that is greater than 750 square millimeters (e.g., greater than 1500 square millimeters, greater than 3000 square millimeters, or greater than 6000 square millimeters). In some embodiments, the large IC die 100 may have at least one lateral dimension 116 or 118 that is greater than 33 millimeters (e.g., greater than 66 millimeters, greater than 99 millimeters, or greater than 132 millimeters).

Different ones of the subvolumes 102 in a large IC die 100 may include different types and/or arrangements of electrical structures. In some embodiments, the subvolume 102-1 may include transistors (e.g., the transistors 1640 discussed below with reference to FIG. 2) having a first structure and the subvolume 102-2 may include transistors having a second structure different from the first structure. For example, the subvolume 102-1 may include planar transistors in the device layer (e.g., the device layer 106 or another device layer) and the subvolume 102-2 may include non-planar transistors in the device layer. Examples of non-planar transistors may include dual-gate transistors, tri-gate transistors, or all-around gate transistors (e.g., nanoribbon transistors or nanowire transistors). Utilizing two different types of transistors in different ones of the subvolumes 102 of a large IC die may allow the transistor type to be tailored to the functional circuitry of which it is a part. For example, planar transistors may be particularly useful for high voltage I/O or logic circuitry, while non-planar transistors (e.g., dual-gate or tri-gate transistors) may be particularly useful for processing unit logic circuitry (e.g., in a central processing unit (CPU)). In another example, the subvolume 102-1 may include dual-gate transistors and the subvolume 102-2 may include tri-gate transistors.

In another example, the transistors in the subvolume 102-1 and the transistors in the subvolume 102-2 may be of the same type (e.g., planar, dual-gate, tri-gate, etc.) but parameters of those transistors may differ between the subvolumes 102. For example, the transistors (e.g., the transistors 1640 discussed below with reference to FIG. 2) in the subvolume 102-1 and the transistors in the subvolume 102-2 may be planar transistors, but the transistors in the subvolume 102-1 may have a different channel thickness and/or gate length than the transistors in the subvolume 102-2. In another example, the transistors in the subvolume 102-1 and the transistors in the subvolume 102-2 may be dual-gate transistors (or tri-gate transistors), but the transistors in the subvolume 102-1 may have a different gate length, fin height as claimed in claim 1 according to the invention, and/or fin width than the transistors in the subvolume 102-2. Utilizing the same type of transistors, but with different dimensions, in different ones of the subvolumes 102 of a large IC die allow the transistor characteristics to be tailored to the functional circuitry of which it is a part. For example, FinFETs having a lower fin height may be well-suited for lower power circuitry (e.g., logic with lower performance) and FinFETS having a higher fin height may be well-suited for higher power circuitry (e.g., logic with higher performance).

In some embodiments, different processing operations may be performed to electrical structures in different ones of the subvolumes 102. For example, in some embodiments, the devices (e.g., the transistors 1640 discussed below with reference to FIG. 2) in the first portion 106-1 of the device layer 106 may be subjected to different local processing conditions (e.g., laser annealing or ion implantation) than the devices in the second portion 106-2. Different types of processing may confer advantages to certain devices (e.g., may modify transistor performance or leakage properties), but may also incur significant process costs; selectively performing such processing in subvolumes 102 in which its advantages may be more fully realized may improve performance without incurring excessive cost.

In some embodiments, different ones of the subvolumes 102 of a large IC die 100 may include different functional circuitry. For example, the subvolume 102-1 may provide a processing unit (e.g., general logic for a CPU, such as a control unit, an arithmetic/logic unit, and/or a register storage area), while the subvolume 102-2 may provide a memory device (e.g., a dynamic random access memory (DRAM) array, including storage cells, sense amplifiers, and word lines, or a static random access memory (SRAM) array).

In some embodiments, the structures of the electrical pathways in the metallization stacks 108 and/or 112 in different ones of the subvolumes 102 of a large IC die 100 may be different. In accordance with the invention as claimed, different materials are used in some of the conductive vias and/or lines (e.g., the conductive lines 1628a and the conductive vias 1628b discussed below with reference to FIG. 2) of the first portion 108-1 of the metallization stack 108 (first portion 112-1 of the metallization stack 112) relative to some of the conductive vias and/or lines of the second portion 108-2 of the metallization stack 108 (second portion 112-2 of the metallization stack 112). In one particular example, some or all conductive vias of the first portion 108-1 (first portion 112-1) may include tungsten (e.g., as a fill material) and some or all conductive vias of the second portion 108-2 (second portion 112-2) may include copper (e.g., as a fill material). In another example, the conductive vias and/or lines in different ones of the subvolumes 102 of a large IC die 100 may have different dimensions; for example, some of the conductive lines in the subvolume 102-1 may be thicker than conductive lines in the corresponding layer of the subvolume 102-2.

In some embodiments, different ones of the subvolumes 102 in a large IC die 100 may share a number of layers having the same structure, and then may have a set of layers that differ. For example, the subvolumes 102-1 and 102-2 may have a first set of layers in the metallization stack 108 (the metallization stack 112) that have the same structure between the subvolumes 102-1 and 102-2 (e.g., the first ten layers) and a second set of layers in the metallization stack 10 (the metallization stack 112) that are different. In such embodiments, a same set of photomasks may be used to pattern the first set of layers of the subvolume 102-1 and the first set of layers of the subvolume 102-2, and different sets of photomasks may be used to pattern the second set of layers of the subvolume 102-1 and the second set of layers of the subvolume 102-2. In some embodiments, the different second set of layers of the subvolume 102-1 and the subvolume 102-2 may be used to pattern special electrical structures, such as a capacitor (e.g., a metal-insulator-metal capacitor), copper bumps, or a magnetic material (e.g., in an inductor). In some embodiments, the different second set of layers of the subvolume 102-1 and the subvolume 102-2 may be used to achieve different dimensions of the conductive lines and/or vias in the subvolume 102-1 and the subvolume 102-2 (e.g., to form thicker conductive lines in the subvolume 102-1 or the subvolume 102-2, as discussed above).

Although only two subvolumes 102 and one stitching subvolume 104 are depicted in FIG. 1, this is simply for ease of illustration, and the techniques and structures disclosed herein may be used to "stitch" together any desired number and arrangement of subvolumes 102 with stitching subvolumes 104 to form a large IC die 100. Different ones of the subvolumes 102 in a large IC die 100 may have the same structure or different structures (e.g., in accordance with any of the embodiments discussed herein). A number of example large IC dies 100 with various arrangements of subvolumes 102 and stitching subvolumes 104 are illustrated herein. In some embodiments, the techniques and structures disclosed herein may be used to form a large IC die 100 whose lateral dimensions are equal or approximately equal to the lateral dimensions of the semiconductor wafer underlying the large IC die 100.

The large IC die 100 illustrated in FIG. 1B is a "double-sided" die in that the large IC die 100 includes top conductive contacts 110 at one face and bottom conductive contacts 114 at the opposite face, allowing electrical connections to the large IC die 100 to be made at both faces. In some embodiments, the large IC dies 100 disclosed herein may only be "single-sided," having only a set of conductive contacts at a single face (e.g., the conductive contacts 110 or the conductive contacts 114). Double-sided large IC dies 100 may be depicted in various ones of the accompanying drawings for illustrative purposes, but any suitable ones of the large IC dies 100 disclosed herein may be single-sided.

FIG. 2 is a side, cross-sectional view showing example details of a large IC die 100. The elements illustrated in and discussed below with reference to FIG. 2 may be embodiments of any of the corresponding elements discussed above with reference to FIG. 1 (or others of the accompanying figures). FIG. 2 also illustrates a subvolume 102-1, a subvolume 102-2, and a stitching subvolume 104 that provides conductive pathways between the subvolume 102-1 and the subvolume 102-2. In the embodiment of FIG. 2, no transistors 1640 are illustrated in the stitching subvolume 104; in various embodiments, the stitching subvolume 104 may or may not include transistors 1640 or other active devices.

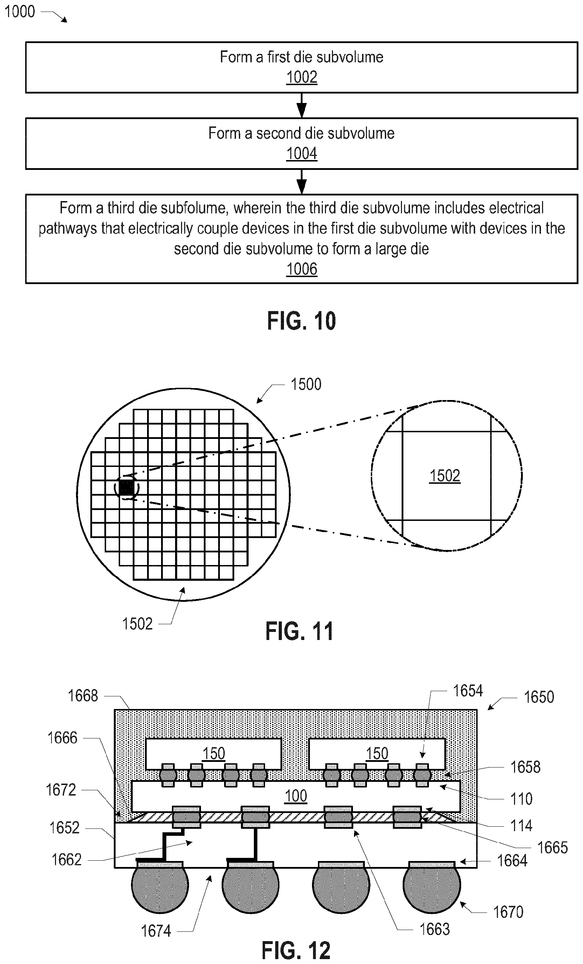

The large IC die 100 may include a substrate 1602 (e.g., the wafer 1500 of FIG. 11). The substrate 1602 may be a semiconductor substrate composed of semiconductor material systems including, for example, n-type or p-type materials systems (or a combination of both). The substrate 1602 may include, for example, a crystalline substrate formed using a bulk silicon or a silicon-on-insulator (SOI) substructure. In some embodiments, the substrate 1602 may be formed using alternative materials, which may or may not be combined with silicon, that include but are not limited to germanium, indium antimonide, lead telluride, indium arsenide, indium phosphide, gallium arsenide, or gallium antimonide. Further materials classified as group II-VI, III-V, or IV may also be used to form the substrate 1602. Although a few examples of materials from which the substrate 1602 may be formed are described here, any material that may serve as a foundation for the large IC die 100 may be used. In some embodiments, the substrate 1602 may be glass. The substrate 1602 may be part of a singulated die (e.g., the dies 1502 of FIG. 11) or a wafer (e.g., the wafer 1500 of FIG. 11).

The device layer 106 may include features of one or more transistors 1640 (e.g., metal oxide semiconductor field-effect transistors (MOSFETs)) formed on an/or in the substrate 1602. The device layer 106 may include, for example, one or more source and/or drain (S/D) regions 1620, a gate 1622 to control current flow in the transistors 1640 between the S/D regions 1620, and one or more S/D contacts 1624 to route electrical signals to/from the S/D regions 1620. The transistors 1640 may include additional features not depicted for the sake of clarity, such as device isolation regions, gate contacts, and the like. The transistors 1640 are not limited to the type and configuration depicted in FIG. 2 and may include a wide variety of other types and configurations such as, for example, planar transistors, non-planar transistors, or a combination of both. Planar transistors may include bipolar junction transistors (BJT), heterojunction bipolar transistors (HBT), or high-electron-mobility transistors (HEMT). Non-planar transistors may include FinFET transistors, such as dual-gate transistors or tri-gate transistors, and wraparound or all-around gate transistors, such as nanoribbon transistors or nanowire transistors.

Each transistor 1640 may include a gate 1622 formed of at least two layers, a gate dielectric and a gate electrode. The gate dielectric may include one layer or a stack of layers. The one or more layers may include silicon oxide, silicon dioxide, silicon carbide, and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one p-type work function metal or n-type work function metal, depending on whether the transistor 1640 is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer. For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 1640 along the source-channel-drain direction, the gate electrode may consist of a U-shaped structure that includes a bottom portion substantially parallel to the surface of the substrate and two sidewall portions that are substantially perpendicular to the top surface of the substrate. In other embodiments, at least one of the metal layers that form the gate electrode may simply be a planar layer that is substantially parallel to the top surface of the substrate and does not include sidewall portions substantially perpendicular to the top surface of the substrate. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 1620 may be formed within the substrate 1602 adjacent to the gate 1622 of each transistor 1640. The S/D regions 1620 may be formed using an implantation/diffusion process or an etching/deposition process, for example. In the former process, dopants such as boron, aluminum, antimony, phosphorous, or arsenic may be ion-implanted into the substrate 1602 to form the S/D regions 1620. An annealing process that activates the dopants and causes them to diffuse farther into the substrate 1602 may follow the ion-implantation process. In the latter process, the substrate 1602 may first be etched to form recesses at the locations of the S/D regions 1620. An epitaxial deposition process may then be carried out to fill the recesses with material that is used to fabricate the S/D regions 1620. In some implementations, the S/D regions 1620 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1620 may be formed using one or more alternate semiconductor materials such as germanium or a group III-V material or alloy. In further embodiments, one or more layers of metal and/or metal alloys may be used to form the S/D regions 1620.

As noted above, electrical signals may be routed to and/or from the devices (e.g., the transistors 1640) of the device layer 106, or other electrical components included in the large IC die 100, through electrically conductive structures 1628 in the metallization stacks 108 and 112. The electrically conductive structures 1628 may be arranged within the metallization stacks 108 and 112 to route electrical signals according to a wide variety of designs (in particular, the arrangement is not limited to the particular configuration of electrically conductive structures 1628 depicted in FIG. 2). Although a particular number of layers is depicted in each of the metallization stacks 108 and 112 of FIG. 2, embodiments of the present disclosure include large IC dies 100 having more or fewer metallization stack layers than depicted.

In some embodiments, the electrically conductive structures 1628 may include lines 1628a and/or vias 1628b filled with an electrically conductive material such as a metal. The lines 1628a may be arranged to route electrical signals in a direction of a plane that is substantially parallel with a surface of the substrate 1602 upon which the device layer 106 is formed. For example, the lines 1628a may route electrical signals in a direction in and out of the page from the perspective of FIG. 2. The vias 1628b may be arranged to route electrical signals in a direction of a plane that is substantially perpendicular to the surface of the substrate 1602 upon which the device layer 106 is formed. In some embodiments, the vias 1628b may electrically couple lines 1628a of different layers in a metallization stack together. Although the lines 1628a and the vias 1628b are structurally delineated with a line within a layer for the sake of clarity, the lines 1628a and the vias 1628b may be structurally and/or materially contiguous (e.g., simultaneously filled during a dual-damascene process) in some embodiments. In some embodiments, the metallization stack layers that are "higher up" (i.e., farther away from the device layer 106) may be thicker. In some embodiments, a through-substrate via 1628b may extend through the substrate 1602 to connect the device layer 106 and/or the top metallization stack 108 with the bottom metallization stack 112 in embodiments in which the large IC die 100 is double-sided.

The metallization stacks 108 and 112 may include a dielectric material 1626 disposed between the electrically conductive structures 1628, as shown in FIG. 2. In some embodiments, the dielectric material 1626 disposed between the electrically conductive structures 1628 in different ones of the layers of the metallization stacks 108 and 112 may have different compositions; in other embodiments, the composition of the dielectric material 1626 between different layers of the metallization stacks 108 and 112 may be the same.

The top conductive contacts 110 and the bottom conductive contacts 114 may be conductive contacts formed on the metallization stacks 108 and 112, respectively, and spaced apart by a solder resist material 1634 (e.g., polyimide or similar material). In FIG. 10, the conductive contacts are illustrated as taking the form of bond pads. The conductive contacts 110 and/or 114 may be electrically coupled with the electrically conductive structures 1628 and configured to route the electrical signals of the transistor(s) 1640 or other electrical elements of the large IC die 100 to other external devices. For example, solder bonds may be formed on the one or more conductive contacts 110 and/or 114 to mechanically and/or electrically couple the large IC die 100 with another component (e.g., another die or a package substrate, as discussed further below). The large IC die 100 may include additional or alternate structures to route the electrical signals from the metallization stacks 108 or 112; for example, the conductive contacts 110 or 114 may include other analogous features (e.g., posts) that route the electrical signals to external components.

As noted above, in embodiments in which a large IC die 100 is double-sided, one or more other IC dies may be coupled to the top conductive contacts 110 and/or the bottom conductive contacts 114. For example, FIG. 3 is a side, cross-sectional view of an IC assembly 200 including a large IC die 100 and two other IC dies 150 coupled to the top conductive contacts 110 of the large IC die 100. Although the large IC die 100 of FIG. 3 is illustrated as including two subvolumes 102 and a stitching subvolume 104, the large IC die 100 may take the form of any of the large IC dies 100 disclosed herein.

Conductive contacts 1654 of the IC dies 150 may be coupled to the large IC die 100 by first-level interconnects 1658. The first-level interconnects 1658 illustrated in FIG. 3 are solder bumps, but any suitable first-level interconnects 1658 may be used. First-level interconnects 1665 may be present on the conductive contacts 114 of the large IC die 100; the first-level interconnects 1665 may be used to couple the large IC die 100 to a package substrate (e.g., as discussed further below with reference to FIG. 12), to an interposer, or to another IC die.

Although the IC dies 150 are depicted in various ones of the accompanying figures as coupled to conductive contacts 110 of the subvolumes 102 of the large IC die 100, this is simply illustrative, and IC dies 150 may be coupled to conductive contacts 110 of a stitching subvolume 104, as suitable. Further, although the large IC die 100 is depicted in various ones of the accompanying figures as having the IC dies 150 coupled to the conductive contacts 110, this is simply illustrative, and IC dies 150 may be coupled to the conductive contacts 114 instead of or in addition to the conductive contacts 110 (and the conductive contacts 110 may be coupled to a package substrate or an interposer, as desired).

In some embodiments, an IC assembly 200 may include the more complex (and therefore lower yield) structures in the smaller IC dies 150 while locating the less complex (and therefore higher yield) structures in the large IC die 100. The size of a large IC die 100 may mean that it is costly to manufacture, and thus a loss of such a die may be expensive; fabricating the large IC die 100 with more reliably manufactured electrical structures may reduce the likelihood that the large IC die 100 will fail to meet performance requirements and will be counted as a loss. Examples of electrical structures that may be suitable for inclusion in the large IC die 100 of an IC assembly 200 may include power delivery structures, DRAM, SRAM, camera sensors, and high yield, low density logic.

FIGS. 4-6 illustrate various arrangements of the large IC die 100 and the other IC dies 150 in example IC assemblies 200. For example, FIG. 4 illustrates an IC assembly 200 having multiple IC dies 150 coupled to a large IC die 100; FIG. 4A is a top view, and FIG. 4B is a side, cross-sectional view through the section A-A of FIG. 4A. In the IC assembly 200 of FIG. 4, the large IC die 100 has four subvolumes 102-1, 102-2, 102-3, and 102-4 arranged in an array and "stitched" together by intervening stitching subvolumes 104-1, 104-2, and 104-3, as shown. The IC dies 150-1, 150-2, 150-3, and 150-4 are coupled to conductive contacts 110 of the subvolumes 102-1, 102-2, 102-3, and 102-4, respectively. Elements of the IC assembly 200 may take the form of corresponding elements of FIG. 2, for example.

In some embodiments of the IC assembly 200 of FIG. 4, the subvolumes 102 of the large IC die 100 may include memory devices, such as SRAM. In some embodiments, one or more of the subvolumes 102 of the large IC die 100 may also include router circuitry. The IC die 150-1 may be a logic die, and the IC dies 150-2 may be artificial intelligence (Al) dies, such as deep neural network (DNN) dies. The IC dies 150-3 may be high bandwidth memory (HBM) dies (e.g., dies in accordance with the HBM or HBM2 standard). Such an embodiment of the IC assembly 200 may provide an Al processing assembly, and may be packaged into an IC package (e.g., as discussed below with reference to the IC package 1650 of FIG. 12). In some embodiments, the lateral dimension 118 of the large IC die 100 of FIG. 4 may be between 40 millimeters and 60 millimeters (e.g., between 44 millimeters and 58 millimeters). In some embodiments, the lateral dimension 116 of the large IC die 100 of FIG. 4 may be between 30 millimeters and 40 millimeters (e.g., between 32 millimeters and 35 millimeters). The area of the IC dies 150-1 and 150-2 may be between 200 square millimeters and 250 square millimeters, and the area of the IC dies 150-3 may be between 80 square millimeters and 100 square millimeters.

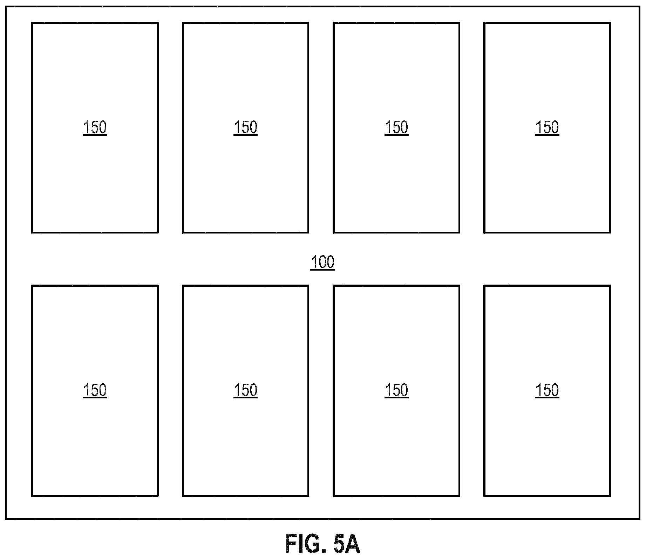

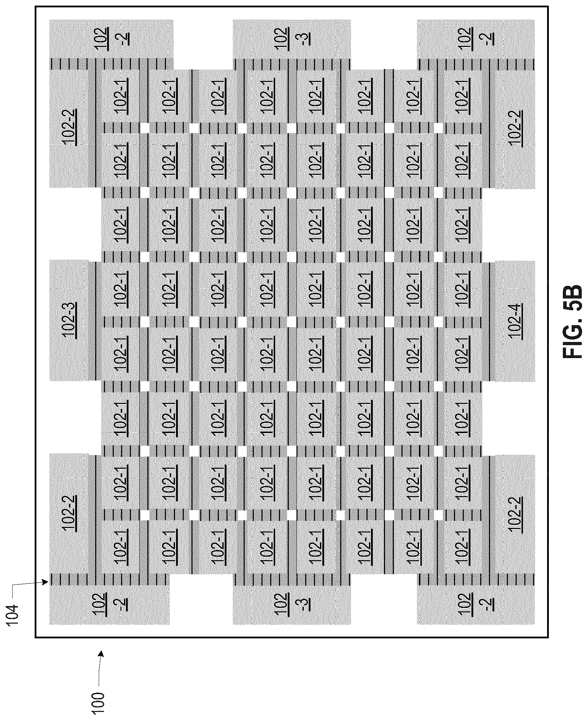

FIG. 5 illustrates an IC assembly 200 having multiple IC dies 150 coupled to a large IC die 100; FIG. 5A is a top view of the IC assembly, omitting details of the large IC die 100, and FIG. 5B is a top view of the large IC die 100. In the IC assembly 200 of FIG. 5, the large IC die 100 has many subvolumes 102 "stitched" together by intervening stitching subvolumes 104, as shown. The IC dies 150 are coupled to conductive contacts (not shown) of the large IC die 100 (e.g., as discussed above with reference to FIG. 3). Elements of the IC assembly 200 of FIG. 5 may take the form of corresponding elements of FIG. 2, for example.

In some embodiments of the IC assembly 200 of FIG. 5, the IC dies 150 may be HBM dies, the subvolumes 102-1 may be computing clusters, the subvolumes 102-2 may be serializer/deserializer (SERDES) circuitry, the subvolumes 102-3 may be HBM controller circuitry (e.g., I/O circuitry for the HBM IC dies 150), and the subvolume 102-4 may be bus circuitry (e.g., Peripheral Component Interconnect Express (PCIe) circuitry). Stitching subvolumes 104 may be arranged in any suitable manner between the subvolumes 102 of the large IC die 100 to achieve a desired pattern of connectivity between the subvolumes 102. In some embodiments, the lateral dimension of the subvolumes 102-1 may be between 4 square millimeters and 6 square millimeters. Although a particular number of subvolumes 102-1 and IC dies 150 are illustrated in FIG. 5, an IC assembly 200 may include more or fewer components (e.g., more than 64 subvolumes 102-1). Such an embodiment of the IC assembly 200 may provide an AI processing assembly, and may be packaged into an IC package (e.g., as discussed below with reference to the IC package 1650 of FIG. 12).

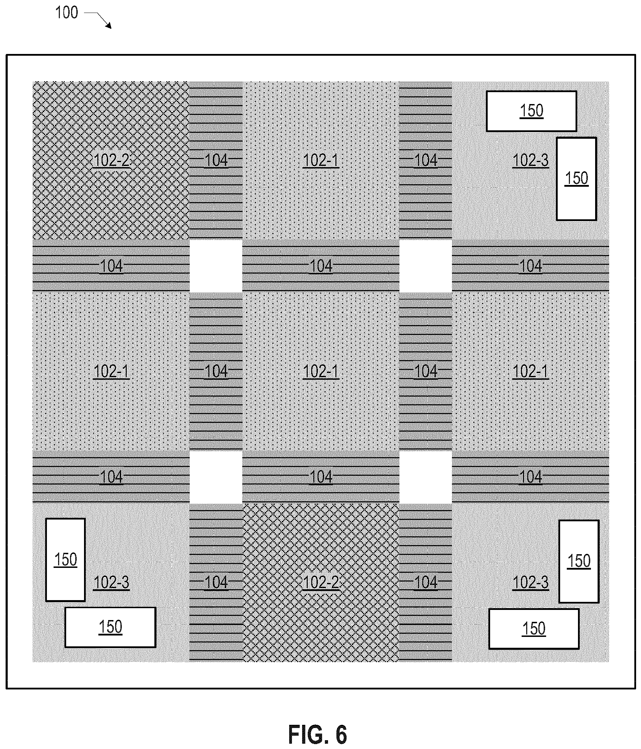

FIG. 6 is a top view of an IC assembly having multiple IC dies 150 coupled to a large IC die 100. In the IC assembly 200 of FIG. 6, the large IC die 100 has many subvolumes 102 "stitched" together by intervening stitching subvolumes 104, as shown. The IC dies 150 are coupled to conductive contacts (not shown) of the large IC die 100 (e.g., as discussed above with reference to FIG. 3). Elements of the IC assembly 200 of FIG. 6 may take the form of corresponding elements of FIG. 2, for example. In some embodiments of the IC assembly 200 of FIG. 6, the IC dies 150 may be HBM dies, the subvolumes 102-1 may be logic circuitry, the subvolumes 102-2 may be memory devices (e.g., SRAM), and the subvolumes 102-3 may include HBM controller circuitry.

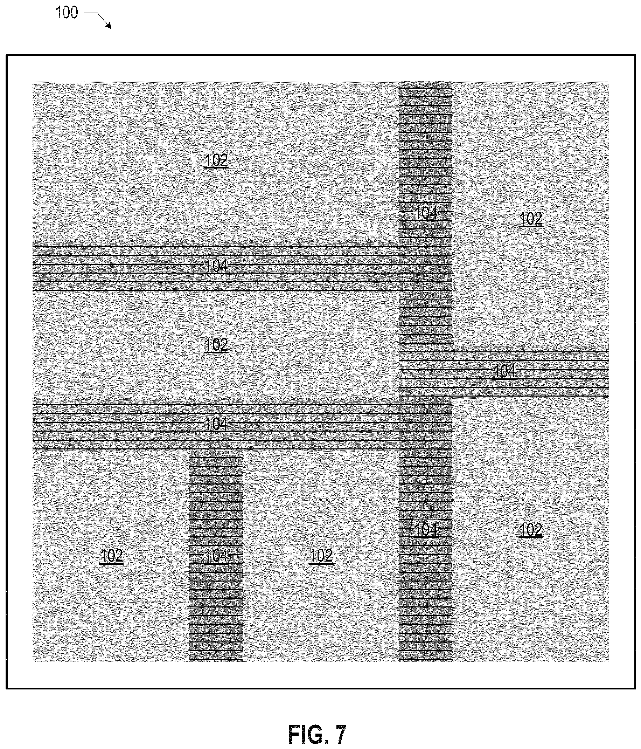

As noted above, although particular types and arrangements of subvolumes 102 and stitching subvolumes 104 are illustrated herein, a large IC die 100 may include any suitable types and arrangements of subvolumes 102 and stitching subvolumes 104. For example, FIG. 7 is a top view of another example large IC die 100, including a number of different subvolumes 102 and stitching subvolumes 104. One or more of the subvolumes 102 (and/or stitching subvolumes 104) may be patterned using the same photomask sets or different photomask sets, as discussed herein.

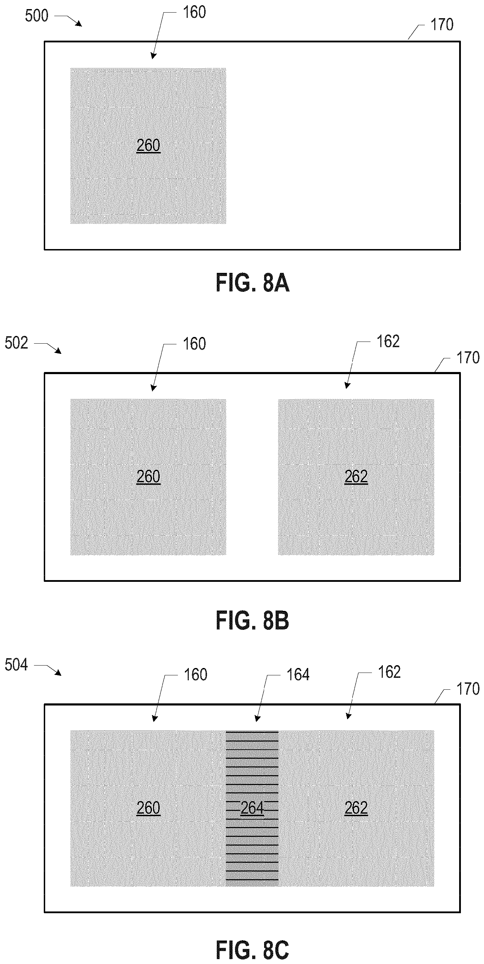

Any suitable manufacturing process may be used to fabricate the large IC dies 100 disclosed herein. For example, FIGS. 8A-8C illustrate stages in an example process of manufacturing a large IC die 100, in accordance with various embodiments. FIG. 8A is a top view of an assembly 500 subsequent to forming features 260 in a first region 160 of an assembly 170 using a first set of photomasks (and any suitable associated processes, such as deposition, polishing, desmear, etc.). The assembly 170 may be the substrate 1602 (e.g., when forming the device layer 106) or any other stage during the fabrication of the large IC die 100.

FIG. 8B is a top view of an assembly 502 subsequent to forming features 262 in a second region 162 of the assembly 502 (FIG. 8A) using a second set of photomasks (and any suitable associated processes). In some embodiments, the first set of photomasks may be the same as the second set of photomasks (and thus the features 260 may be the same as the features 262), while in other embodiments, the first set of photomasks may be different than the second set of photomasks (and thus the features 260 may be different than the features 262).

FIG. 8C is a top view of an assembly 504 subsequent to forming features 264 in a third region 164 of the assembly 502 (FIG. 8B) using a third set of photomasks (and any suitable associated processes). The features 264 may electrically "stitch" some of the features 260 of the first region 160 with some of the features 262 of the second region 162. The operations of FIGS. 8A-8C may be repeated so that the features formed in the first region 160 provide the subvolume 102-1, the features formed in the second region 162 provide the subvolume 102-2, and the features formed in the third region 164 provide the stitching subvolume 104 of a large IC die 100.

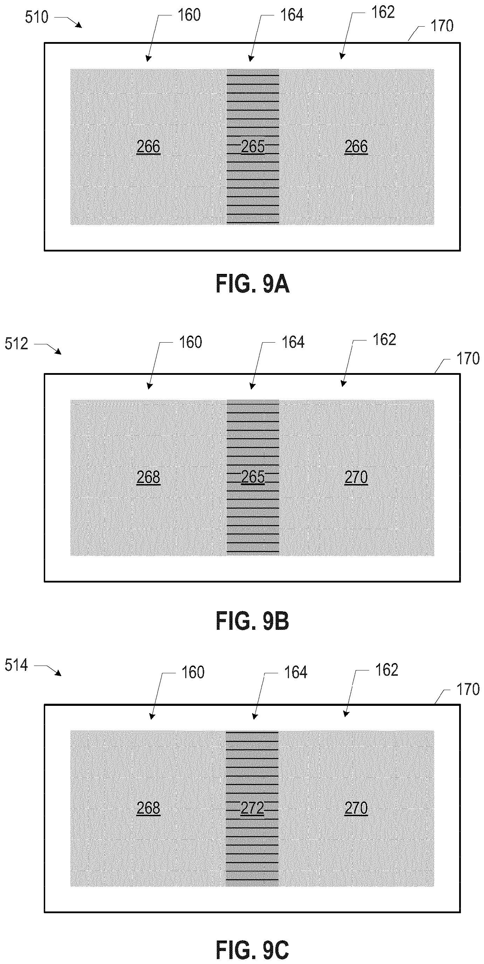

FIGS. 9A-9C illustrate stages in an example process of manufacturing a large IC die 100, in accordance with various embodiments. FIG. 9A is a top view of an assembly 510 subsequent to forming features 266 in a first region 160 and in a second region 162 of an assembly 170 using a first set of photomasks (and any suitable associated processes, such as deposition, polishing, desmear, etc.), and forming features 265 in a third region 164 of the assembly 170 using a second set of photomasks (and any suitable associated processes). The features 265 may electrically "stitch" some of the features 266 of the first region 160 with some of the features 266 of the second region 162. The features 266 may be formed in the first region 160 and in the second region 162 in parallel, or in series, as suitable. The assembly 170 may take any of the forms discussed above with reference to FIG. 9A.

FIG. 9B is a top view of an assembly 512 subsequent to forming features 268 in the first region 160 of the assembly 510 (FIG. 9A) using a third set of photomasks (and any suitable associated processes), and forming features 270 in the second region 162 of the assembly 510 (FIG. 9A) using a fourth set of photomasks (and any suitable associated processes). The third set of photomasks may be different than the fourth set of photomasks (and thus the features 268 may be different than the features 270).

FIG. 9C is a top view of an assembly 514 subsequent to forming features 272 in the third region 164 of the assembly 512 (FIG. 9B) using a fifth set of photomasks (and any suitable associated processes). The features 272 may electrically "stitch" some of the features 268 of the first region 160 with some of the features 270 of the second region 162. The operations of FIGS. 9A-9C may be repeated (and modified as suitable) so that the features in the first region 160 provide the subvolume 102-1, the features formed in the second region 162 provide the second subvolume 102-2, and the features formed in the third region 164 provide the stitching subvolume 104 of a large IC die 100.

FIG. 10 is a flow diagram of an example method 1000 of manufacturing a large IC die, in accordance with various embodiments. Although the operations of the method 1000 may be illustrated with reference to particular embodiments of the large IC dies 100 disclosed herein, the method 1000 may be used to form any suitable large IC die. Operations are illustrated once each and in a particular order in FIG. 10, but the operations may be reordered and/or repeated as desired (e.g., with different operations performed in parallel when manufacturing multiple electronic components simultaneously). For example, the operations of 1002, 1004, and 1006 may be performed in an interleaved manner, with portions of the first die subvolume, the second die subvolume, and the third die subvolume being fabricated alternatingly.

At 1002, a first die subvolume may be formed. The first die subvolume may take the form of any of the subvolumes 102 disclosed herein, and may be formed using any of the techniques disclosed herein.

At 1004, a second die subvolume may be formed. The second die subvolume may take the form of any of the subvolumes 102 disclosed herein, and may be formed using any of the techniques disclosed herein.

At 1006, a third die subvolume may be formed. The third die subvolume may include electrical pathways that electrically couple devices in the first die subvolume with devices in the second die subvolume to form a large die. The third die subvolume may take the form of any of the stitching subvolumes 104 disclosed herein, and may be formed using any of the techniques disclosed herein. The large die may take the form of any of the large IC dies 100 disclosed herein, for example.

The large IC dies 100 disclosed herein may be included in any suitable electronic component. FIGS. 11-14 illustrate various examples of apparatuses that may include any of the large IC dies 100 disclosed herein.

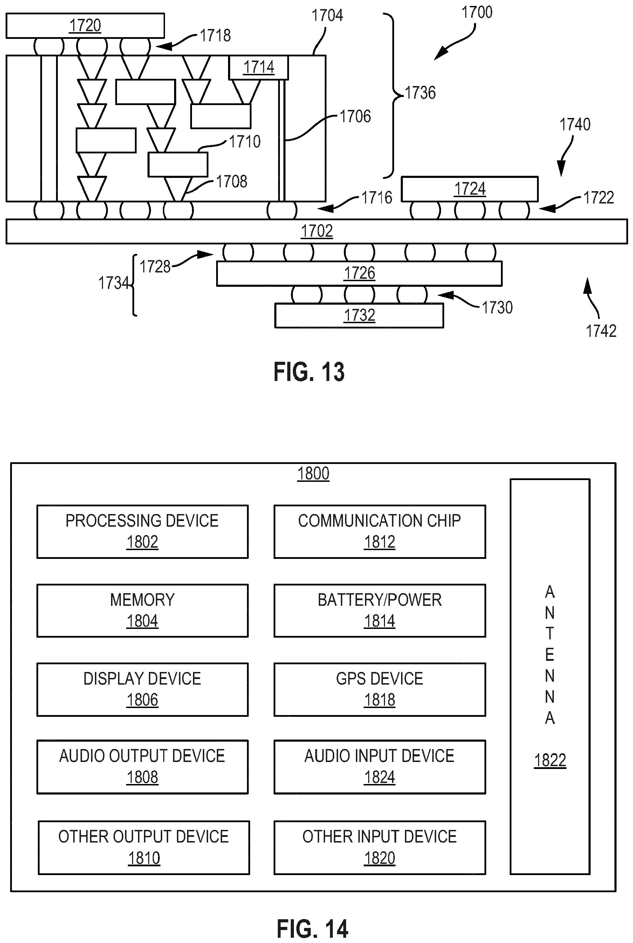

FIG. 11 is a top view of a wafer 1500 and dies 1502 that may include one or more large IC dies 100, or may be included in an IC package including one or more large IC dies 100 (e.g., as discussed below with reference to FIG. 12) in accordance with any of the embodiments disclosed herein. The wafer 1500 may be composed of semiconductor material or a non-semiconductor material, such as glass, and may include one or more dies 1502 having IC structures formed on a surface of the wafer 1500. Each of the dies 1502 may be a repeating unit of a semiconductor product that includes any suitable IC. After the fabrication of the semiconductor product is complete, the wafer 1500 may undergo a singulation process in which the dies 1502 are separated from one another to provide discrete "chips" of the semiconductor product. In some embodiments, the die 1502 may be the size of the entire wafer (e.g., when the die 1502 is a large IC die 100), and thus no singulation may be required. The die 1502 may take the form of any of the large IC dies 100 or IC dies 150 disclosed herein. In some embodiments, the wafer 1500 or the die 1502 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 14) or other logic that is configured to store information in the memory devices or execute instructions stored in the memory array.

FIG. 12 is a side, cross-sectional view of an example IC package 1650 that may include one or more large IC dies 100. In particular, FIG. 12 illustrates an IC package 1650 including the IC assembly 200 of FIG. 3; other elements (not shown) may also be included in the IC package 1650. In some embodiments, the IC package 1650 may be a system-in-package (SiP).

The package substrate 1652 may be formed of an organic dielectric material (e.g., a ceramic, a buildup film, an epoxy film having filler particles therein, etc.), and may have conductive pathways extending through the dielectric material between the face 1672 and the face 1674, or between different locations on the face 1672, and/or between different locations on the face 1674. These conductive pathways may take the form of any of the electrically conductive structures 1628 discussed above with reference to FIG. 2. In some embodiments, the package substrate 1652 may be formed as a printed circuit board (PCB), as discussed below with reference to FIG. 13.

The package substrate 1652 may include conductive contacts 1663 that are coupled to conductive pathways 1662 through the package substrate 1652, allowing circuitry within the IC dies 150 and/or the large IC die 100 to electrically couple to various ones of the conductive contacts 1664. The large IC die 100 may be coupled to the conductive contacts 1663 of the package substrate 1652 by first-level interconnects 1665. The first-level interconnects 1665 illustrated in FIG. 12 are solder bumps, but any suitable first-level interconnects 1665 may be used.

In some embodiments, an underfill material 1666 may be disposed between the package substrate 1652 and the large IC die 100 around the first-level interconnects 1665, and a mold compound 1668 may be disposed around the IC dies 150 and the large IC die 100 and in contact with the package substrate 1652. In some embodiments, the underfill material 1666 may be the same as the mold compound 1668. Example materials that may be used for the underfill material 1666 and the mold compound 1668 are epoxy mold materials, as suitable. Second-level interconnects 1670 may be coupled to the conductive contacts 1664. The second-level interconnects 1670 illustrated in FIG. 12 are solder balls (e.g., for a ball grid array arrangement), but any suitable second-level interconnects 16770 may be used (e.g., pins in a pin grid array arrangement or lands in a land grid array arrangement). The second-level interconnects 1670 may be used to couple the IC package 1650 to another component, such as a circuit board (e.g., a motherboard), an interposer, or another IC package, as known in the art and as discussed below with reference to FIG. 13.

In embodiments in which the IC package 1650 includes multiple dies 100/150, the IC package 1650 may be referred to as a multi-chip package (MCP). Although the IC package 1650 illustrated in FIG. 12 is a flip chip package, other package architectures may be used. For example, the IC package 1650 may be a ball grid array (BGA) package, such as an embedded wafer-level ball grid array (eWLB) package. In another example, the IC package 1650 may be a wafer-level chip scale package (WLCSP) or a panel fanout (FO) package. Although a particular number of IC dies 100/150 are illustrated in the IC package 1650 of FIG. 12, an IC package 1650 may include any desired number of dies 100/150. An IC package 1650 may include additional passive components, such as surface-mount resistors, capacitors, and inductors disposed on the first face 1672 or the second face 1674 of the package substrate 1652, or on either face of the large IC die 100. More generally, an IC package 1650 may include any other active or passive components known in the art.

FIG. 13 is a side, cross-sectional view of an IC device assembly 1700 that may include one or more IC packages including one or more large IC dies 100, in accordance with any of the embodiments disclosed herein. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. Any of the IC packages discussed below with reference to the IC device assembly 1700 may take the form of any of the embodiments of the IC package 1650 discussed above with reference to FIG. 12 (e.g., may include one or more large IC dies 100).

In some embodiments, the circuit board 1702 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The IC device assembly 1700 illustrated in FIG. 13 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702, and may include solder balls (as shown in FIG. 13), male and female portions of a socket, an adhesive, an underfill material, and/or any other suitable electrical and/or mechanical coupling structure.

The package-on-interposer structure 1736 may include an IC package 1720 coupled to a package interposer 1704 by coupling components 1718. The coupling components 1718 may take any suitable form for the application, such as the forms discussed above with reference to the coupling components 1716. Although a single IC package 1720 is shown in FIG. 13, multiple IC packages may be coupled to the package interposer 1704; indeed, additional interposers may be coupled to the package interposer 1704. The package interposer 1704 may provide an intervening substrate used to bridge the circuit board 1702 and the IC package 1720. The IC package 1720 may be or include, for example, any of the dies disclosed herein. Generally, the package interposer 1704 may spread a connection to a wider pitch or reroute a connection to a different connection. For example, the package interposer 1704 may couple the IC package 1720 (e.g., a die) to a set of BGA conductive contacts of the coupling components 1716 for coupling to the circuit board 1702. In the embodiment illustrated in FIG. 13, the IC package 1720 and the circuit board 1702 are attached to opposing sides of the package interposer 1704; in other embodiments, the IC package 1720 and the circuit board 1702 may be attached to a same side of the package interposer 1704. In some embodiments, three or more components may be interconnected by way of the package interposer 1704.

In some embodiments, the package interposer 1704 may be formed as a printed circuit board (PCB), including multiple metal layers separated from one another by layers of dielectric material and interconnected by electrically conductive vias. In some embodiments, the package interposer 1704 may be formed of an epoxy resin, a fiberglass-reinforced epoxy resin, an epoxy resin with inorganic fillers, a ceramic material, or a polymer material such as polyimide. In some embodiments, the package interposer 1704 may be formed of alternate rigid or flexible materials that may include the same materials described above for use in a semiconductor substrate, such as silicon, germanium, and other group III-V and group IV materials. The package interposer 1704 may include metal interconnects 1708 and vias 1710, including but not limited to through-silicon vias (TSVs) 1706. The package interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the package interposer 1704. The package-on-interposer structure 1736 may take the form of any of the package-on-interposer structures known in the art.

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 13 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 14 is a block diagram of an example electrical device 1800 that may include one or more large IC dies 100, in accordance with any of the embodiments disclosed herein. For example, any suitable ones of the components of the electrical device 1800 may include one or more of the IC device assemblies 1700, IC packages 1650, or large IC dies 100 disclosed herein. A number of components are illustrated in FIG. 14 as included in the electrical device 1800, but any one or more of these components may be omitted or duplicated, as suitable for the application. In some embodiments, some or all of the components included in the electrical device 1800 may be attached to one or more motherboards. In some embodiments, some or all of these components are fabricated onto a single system-on-a-chip (SoC) die.

Additionally, in various embodiments, the electrical device 1800 may not include one or more of the components illustrated in FIG. 14, but the electrical device 1800 may include interface circuitry for coupling to the one or more components. For example, the electrical device 1800 may not include a display device 1806, but may include display device interface circuitry (e.g., a connector and driver circuitry) to which a display device 1806 may be coupled. In another set of examples, the electrical device 1800 may not include an audio input device 1824 or an audio output device 1808, but may include audio input or output device interface circuitry (e.g., connectors and supporting circuitry) to which an audio input device 1824 or audio output device 1808 may be coupled. A housing (not shown) may be disposed around one or more components of the electrical device 1800.

The electrical device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific integrated circuits (ASICs), CPUs, graphics processing units (GPUs), cryptoprocessors (specialized processors that execute cryptographic algorithms within hardware), server processors, or any other suitable processing devices. The electrical device 1800 may include a memory 1804, which may itself include one or more memory devices such as volatile memory (e.g., DRAM), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded DRAM (eDRAM) or spin transfer torque magnetic random access memory (STT-MRAM).

In some embodiments, the electrical device 1800 may include a communication chip 1812 (e.g., one or more communication chips). For example, the communication chip 1812 may be configured for managing wireless communications for the transfer of data to and from the electrical device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 1812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 1812 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1812 may operate in accordance with other wireless protocols in other embodiments. The electrical device 1800 may include an antenna 1822 to facilitate wireless communications and/or to receive other wireless communications (such as AM or FM radio transmissions).

In some embodiments, the communication chip 1812 may manage wired communications, such as electrical, optical, or any other suitable communication protocols (e.g., the Ethernet). As noted above, the communication chip 1812 may include multiple communication chips. For instance, a first communication chip 1812 may be dedicated to shorter-range wireless communications such as Wi-Fi or Bluetooth, and a second communication chip 1812 may be dedicated to longer-range wireless communications such as global positioning system (GPS), EDGE, GPRS, CDMA, WiMAX, LTE, EV-DO, or others. In some embodiments, a first communication chip 1812 may be dedicated to wireless communications, and a second communication chip 1812 may be dedicated to wired communications.

The electrical device 1800 may include battery/power circuitry 1814. The battery/power circuitry 1814 may include one or more energy storage devices (e.g., batteries or capacitors) and/or circuitry for coupling components of the electrical device 1800 to an energy source separate from the electrical device 1800 (e.g., AC line power).

The electrical device 1800 may include a display device 1806 (or corresponding interface circuitry, as discussed above). The display device 1806 may include any visual indicators, such as a heads-up display, a computer monitor, a projector, a touchscreen display, a liquid crystal display (LCD), a light-emitting diode display, or a flat panel display.

The electrical device 1800 may include an audio output device 1808 (or corresponding interface circuitry, as discussed above). The audio output device 1808 may include any device that generates an audible indicator, such as speakers, headsets, or earbuds.

The electrical device 1800 may include an audio input device 1824 (or corresponding interface circuitry, as discussed above). The audio input device 1824 may include any device that generates a signal representative of a sound, such as microphones, microphone arrays, or digital instruments (e.g., instruments having a musical instrument digital interface (MIDI) output).

The electrical device 1800 may include a GPS device 1818 (or corresponding interface circuitry, as discussed above). The GPS device 1818 may be in communication with a satellite-based system and may receive a location of the electrical device 1800, as known in the art.

The electrical device 1800 may include an other output device 1810 (or corresponding interface circuitry, as discussed above). Examples of the other output device 1810 may include an audio codec, a video codec, a printer, a wired or wireless transmitter for providing information to other devices, or an additional storage device.

The electrical device 1800 may include an other input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The electrical device 1800 may have any desired form factor, such as a handheld or mobile electrical device (e.g., a cell phone, a smart phone, a mobile internet device, a music player, a tablet computer, a laptop computer, a netbook computer, an ultrabook computer, a personal digital assistant (PDA), an ultra mobile personal computer, etc.), a desktop electrical device, a server device or other networked computing component, a printer, a scanner, a monitor, a set-top box, an entertainment control unit, a vehicle control unit, a digital camera, a digital video recorder, or a wearable electrical device. In some embodiments, the electrical device 1800 may be any other electronic device that processes data.

## Claims

1. An integrated circuit, IC, die (100), comprising:
a first subvolume (102-1) including first electrical structures, wherein the first electrical structures include devices in a first portion of a device layer (106) of the IC die (100), wherein electrical structures include power delivery structures, dynamic random access memory, DRAM, static random access memory, SRAM, camera sensors, and high yield, low density logic, wherein the first electrical structures provide a processing unit and include first conductive vias;
a second subvolume (102-2) including second electrical structures, wherein the second electrical structures include devices in a second portion of the device layer (106) of the IC die (100), wherein the second electrical structures provide a memory device and include second conductive vias, and the first conductive vias have a material composition different than a material composition of the second conductive vias, wherein the devices in the first portion of the device layer (106) of the IC die (100) include tri-gate transistors having a first fin height, the devices in the second portion of the device layer (106) of the IC die (100) include tri-gate transistors having a second fin height, and the first fin height is different than the second fin height; and
a third subvolume including electrical pathways between the first subvolume (102-1) and the second subvolume (102-2);
wherein the IC die has an area greater than 750 square millimeters.

2. The IC die (100) of claim 1, wherein the IC die (100) has a lateral dimension (116, 118) greater than 33 millimeters.

3. The IC die (100) of claim 2, wherein the lateral dimension (116, 118) is a first lateral dimension (116, 118), and the IC die (100) also has a second lateral dimension (116, 118) greater than 22 millimeters.

4. The IC die (100) of claim 1, wherein the third subvolume includes a first set of metallization layers and a second set of metallization layers, the first set of metallization layers is between the second set of metallization layers and the device layer (106), and the first set of metallization layers does not include any electrical pathways.

5. The IC die (100) of claim 1, wherein the memory device includes static random access memory, SRAM, devices or dynamic random access memory, DRAM, devices.

6. The IC die (100) of claim 1, wherein metallization of the third subvolume connects metallization of the first subvolume (102-1) with metallization of the second subvolume (102-2).

## Patentansprüche

1. Integrierter Schaltungs-Chip, IC-Chip, (100), umfassend:
ein erstes Teilvolumen (102-1), das erste elektrischen Strukturen enthält, wobei die ersten elektrischen Strukturen Vorrichtungen in einem ersten Abschnitt einer Vorrichtungsschicht (106) des IC-Chips (100) enthalten, wobei elektrische Strukturen Stromversorgungsstrukturen, dynamischen Direktzugriffsspeicher, DRAM, statischen Direktzugriffsspeicher, SRAM, Kamerasensoren und Logik mit hoher Ausbeute und niedriger Dichte umfassen, wobei die ersten elektrischen Strukturen eine Verarbeitungseinheit bereitstellen und erste leitfähige Durchgänge enthalten;
ein zweites Teilvolumen (102-2), das zweite elektrische Strukturen enthält, wobei die zweiten elektrischen Strukturen Vorrichtungen in einem zweiten Abschnitt der Vorrichtungsschicht (106) des IC-Chips (100) enthalten, wobei die zweiten elektrischen Strukturen eine Speichervorrichtung bereitstellen und zweite leitfähige Durchkontaktierungen enthalten und die ersten leitfähigen Durchkontaktierungen eine Materialzusammensetzung aufweisen, die sich von einer Materialzusammensetzung der zweiten leitfähigen Durchkontaktierungen unterscheidet, wobei die Vorrichtungen in dem ersten Abschnitt der Vorrichtungsschicht (106) des IC-Chips (100) Tri-Gate-Transistoren mit einer ersten Rippenhöhe enthalten, wobei die Vorrichtungen im zweiten Abschnitt der Vorichtungsschicht (106) des IC-Chips (100) Tri-Gate-Transistoren mit einer zweiten Rippenhöhe umfassen, und die erste Rippenhöhe sich von der zweiten Rippenhöhe unterscheidet; und
ein drittes Teilvolumen, das elektrische Pfade zwischen dem ersten Teilvolumen (102-1) und dem zweiten Teilvolumen (102-2) enthält;
wobei der IC Chip eine Fläche von mehr als 750 Quadratmillimetern aufweist.

2. IC-Chip (100) nach Anspruch 1, wobei der IC-Chip (100) eine seitliche Abmessung (116, 118) von mehr als 33 Millimetern aufweist.

3. IC Chip (100) nach Anspruch 2, wobei die seitliche Abmessung (116, 118) eine erste seitliche Abmessung (116, 118) ist und der IC Chip (100) auch eine zweite seitliche Abmessung (116, 118) von mehr als 22 Millimetern aufweist.

4. IC-Chip (100) nach Anspruch 1, wobei das dritte Teilvolumen einen ersten Satz von Metallisierungsschichten und einen zweiten Satz von Metallisierungsschichten enthält, der erste Satz von Metallisierungsschichten zwischen dem zweiten Satz von Metallisierungsschichten und der Vorrichtungsschicht (106) liegt und der erste Satz von Metallisierungsschichten keine elektrischen Pfade enthält.

5. IC-Chip (100) nach Anspruch 1, wobei die Speichervorrichtung statische Direktzugriffsspeicher-, SRAM-, Vorrichtungen oder dynamische Direktzugriffsspeicher-, DRAM-, Vorrichtungen enthält.

6. IC-Chip (100) nach Anspruch 1, wobei die Metallisierung des dritten Teilvolumens die Metallisierung des ersten Teilvolumens (102-1) mit der Metallisierung des zweiten Teilvolumens (102-2) verbindet.

## Revendications

1. Puce à circuit intégré, IC, (100) comprenant :
un premier sous-volume (102-1) comprenant des premières structures électriques, où les premières structures électriques comprennent des dispositifs dans une première partie d'une couche de dispositif (106) de la puce de circuit intégré IC (100), où les structures électriques comprennent des structures de distribution d'énergie, une mémoire vive dynamique, DRAM, une mémoire vive statique, SRAM, des capteurs de caméra, et une logique à rendement élevé et à faible densité, où les premières structures électriques fournissent une unité de traitement et comprennent les premiers trous d'interconnexion conducteurs ;
un deuxième sous-volume (102-2) comprenant des deuxièmes structures électriques, où les deuxièmes structures électriques comprennent des dispositifs dans une deuxième partie de la couche de dispositif (106) de la puce de circuit intégré IC (100), où les deuxièmes structures électriques fournissent un dispositif de mémoire et comprennent des deuxièmes trous d'interconnexion conducteurs, et les premiers trous d'interconnexion conducteurs ont une composition de matériau différente de la composition de matériau des deuxièmes trous d'interconnexion conducteurs, où les dispositifs de la première partie de la couche de dispositif (106) de la puce de circuit intégré IC (100) comprennent des transistors à trois portes ayant une première hauteur d'ailette, les dispositifs de la deuxième partie de la couche de dispositif (106) de la puce de circuit intégré IC (100) comprennent des transistors à trois portes ayant une deuxième hauteur d'ailette, et la première hauteur d'ailette est différente de la deuxième hauteur d'ailette ; et
un troisième sous-volume comprenant des voies électriques entre le premier sous-volume (102-1) et le deuxième sous-volume (102-2) ;
où la puce de circuit intégré IC a une surface supérieure à 750 millimètres carrés.

2. Puce IC (100) selon la revendication 1, où la puce IC (100) a une dimension latérale (116, 118) supérieure à 33 millimètres.

3. Puce IC (100) selon la revendication 2, où la dimension latérale (116, 118) est une première dimension latérale (116, 118), et la puce IC (100) a également une deuxième dimension latérale (116, 118) supérieure à 22 millimètres.

4. Puce IC (100) selon la revendication 1, où le troisième sous-volume comprend un premier ensemble de couches de métallisation et un deuxième ensemble de couches de métallisation, le premier ensemble de couches de métallisation se trouvant entre le deuxième ensemble de couches de métallisation et la couche de dispositif (106), et le premier ensemble de couches de métallisation ne comprenant pas de voies électriques.

5. Puce IC (100) selon la revendication 1, où le dispositif de mémoire comprend des dispositifs de mémoire vive statique, SRAM, ou des dispositifs de mémoire vive dynamique, DRAM.

6. Puce IC (100) selon la revendication 1, où la métallisation du troisième sous-volume relie la métallisation du premier sous-volume (102-1) à la métallisation du deuxième sous-volume (102-2).
